# EUROPEAN PATENT SPECIFICATION

(11) **EP 4 453 589 B1**
(45) Date of publication and mention of the grant of the patent: **13.05.2026**
(21) Application number: 22829945.9
(22) Date of filing: 15.12.2022
(51) Int. Cl.: G01R 31/388, G01R 31/392

(54) **METHOD FOR DEGRADATION DIAGNOSIS OF AN ELECTROCHEMICAL CELL**
VERFAHREN ZUR DIAGNOSE DES ABBAUS EINER ELEKTROCHEMISCHEN ZELLE
PROCÉDÉ DE DIAGNOSTIC DE DÉGRADATION D'UNE CELLULE ÉLECTROCHIMIQUE

(30) Priority: 21.12.2021 SE 2151573
(43) Date of publication of application: 30.10.2024
(73) Proprietor: Scania CV AB, 151 87 Södertälje (SE)
(72) Inventor: LACEY, Matthew, 647 35 Mariefred (SE); KLETT HUDSON, Matilda, 113 54 Stockholm (SE)
(74) Representative: Scania CV AB
(86) International application number: PCT/SE2022/051179
(87) International publication number: WO 2023/121538

(56) References cited:
- JP-A- 2012 137 330
- JP-A- 2012 141 202
- KR-A- 20130 136 800
- ROBERT KOSTECKI ET AL: "G.7 Study of Cathode Degradation in Gen 2 High Power Lithium-IOn Cells", DIAGNOSTIC EXAMINATION OF GENERATION 2 LITHIUM-ION CELLS AND ASSESSMENT OF PERFORMANCE DEGRADATION MECHANISMS, 31 July 2005 (2005-07-31), Argonne national Laboratory, pages 1 - 196, XP055355445, Retrieved from the Internet <URL:http://www.ipd.anl.gov/anlpubs/2005/07/53944.pdf> [retrieved on 20170316]
- MARONGIU ANDREA ET AL: "On-board capacity estimation of lithium iron phosphate batteries by means of half-cell curves", JOURNAL OF POWER SOURCES, ELSEVIER, AMSTERDAM, NL, vol. 324, 26 May 2016 (2016-05-26), pages 158 - 169, XP029624586, ISSN: 0378-7753, DOI: 10.1016/J.JPOWSOUR.2016.05.041
- ABRAHAM DANIEL P.: "Diagnostic Examination of Generation 2 Lithium-Ion Cells and Assessment of Performance Degradation Mechanisms", CHEMICAL ENGINEERING DIVISION ARGONNE NATIONAL LABORATORY, vol. ANL-05/21, 1 July 2005 (2005-07-01), pages 1 - 196, XP055830374
- DUBARRY MATTHIEU ET AL: "Perspective on Commercial Li-ion Battery Testing, Best Practices for Simple and Effective Protocols", ELECTRONICS, vol. 9, no. 1, 14 January 2020 (2020-01-14), pages 1 - 16, XP055814034, DOI: 10.3390/electronics9010152

## Description

### TECHNICAL FIELD

The present disclosure relates in general to a method for degradation diagnosis of an electrochemical cell.

### BACKGROUND

The effort to reduce emissions and improve fuel economy of heavy vehicles, such as trucks and buses, has led to the development of vehicles comprising propulsion systems that uses one or more electrical machines. These electrical machines may be powered by energy storage devices, such as energy storage devices comprising secondary lithium-ion batteries, that require charging at designated charging stations or zones. Examples of such vehicles include Hybrid Electric Vehicles (HEVs), Plug-in Hybrid Electric Vehicles (PHEVs), and Battery Electric Vehicles (BEVs).

Energy storage devices for vehicles, such as secondary lithium-ion energy storage devices, are built up from a number of individual electrochemical cells. These electrochemical cells can store or release energy through electrochemical reactions. Each electrochemical cell comprises an anode, a cathode and an electrolyte between the anode and the cathode. The electrolyte is an electrically insulating, but ionically conducting electrolyte enabling ions to move through the electrochemical cell. The electrochemical cell further comprises a separator arranged between the anode and cathode. The separator is configured to contain the electrolyte and to prevent short circuit between the anode and the cathode.

The service life of an energy storage device, used for powering the electrical machine(s) of the vehicle, is an essential factor when considering the total life cost of the vehicle. Thus, there is a continuous effort to increase the service life of such energy storage devices. The service life of an energy storage device is dependent of the configuration of the energy storage device as such, for example by the selection of constituent materials of the energy storage device (such as the electrolyte and/or the electroactive materials). The service life is also affected by how the energy storage device is operated. In other words, the service life of an energy storage device is affected by for example how it is charged and discharged. For example, a low charging rate may in general lead to a lower risk of aging of energy storage device. However, this in turn also leads to an increase of the duration of the charging procedure, which may lead to longer times the vehicle is out of service.

Li-ion electrochemical cells degrade through a variety of parasitic chemical reactions which can take place at both the positive and negative electrodes in the cell. Understanding the degradation of the electrochemical cell may be very important, both for the purpose of development of alternative configurations of electrochemical cells for increasing the service life of energy storage devices as well as evaluating the possibly for adapting control methods for the operation of an energy storage device comprising the electrochemical cell to thereby achieve a longer service life.

In practice, the extent of degradation can be distributed very differently throughout the electrode area within a cell. In an automotive Li-ion cell, there may typically be about 1 m² of electrode area for each electrode wound in a package often less than 0.5 L in volume. Uneven, or heterogeneous, degradation drives increasingly rapid degradation, which results in increasingly rapid loss of capacity and/or power of the cell.

One of the most significant consequences of degradation is known as loss of lithium inventory (LLI). LLI is the result of different rates of degradation at each electrode which create a mismatch in the availability of lithium ions in each electrode, degrading the accessible capacity of the complete cell. In recent years, a number of academic groups have developed methods for determining LLI and other degradation consequences such as loss of active material (LAM), through analysis of cell voltage.

One example of a previously known method relies on extracting the electrodes from the electrochemical cell, taking a small sample of each of the electrodes and forming a miniature test cell comprising said samples. Said miniature test cell is thereafter subjected to cycling and the cycling performance is recorded. This method is however very time consuming, primarily due to the duration for cycling of the miniature test cell which typically takes at least several hours. It may also require specific measures to be taken, before assembly into the miniature test cell, due to the electrodes typically comprising two layers of the electrode active material separated by the current collector. Before assembling the miniature test cell, one of these layers has to be removed (without damaging the other layer) from the current collector in order to allow proper electrical connection to the current collector. This is also quite time consuming and therefore adds to the total duration for the diagnosis. Furthermore, if desiring to investigate heterogenous aging of the electrochemical cell, a very large number of miniature cells would have to be tested which would naturally be even more time consuming and therefore also quite costly.

JP 2012 141202 A discloses an open circuit voltage characteristics estimation method for a nonaqueous electrolyte secondary battery on a long-term basis. Furthermore, KR20130136800A discloses a method for estimating the state of a secondary battery.

### SUMMARY

The object of the present invention is to enable faster degradation diagnosis of an electrochemical cell.

The object is achieved by the subject-matter of the appended independent claim.

In accordance with the present disclosure, a method for degradation diagnosis of an electrochemical cell is provided. The method comprises the following steps:
a) by usage of a reference electrode, determining a first open circuit potential, relative to a preselected potential scale, for a positive electrode extracted from the electrochemical cell and determining a second open circuit potential, relative to the preselected potential scale, for a negative electrode extracted from the electrochemical cell;
b) obtaining a first charge value by comparing the determined first open circuit potential to a first reference curve of open circuit potential, relative to the preselected potential scale, as a function of charge for the positive electrode;
c) obtaining a second charge value by comparing the determined second open circuit potential to a second reference curve of open circuit potential, relative to the preselected potential scale, as a function of charge for the negative electrode;
d) arranging the first reference curve and the second reference curve on a common charge scale so that the obtained first charge value and the obtained second charge value are equal for the first and second reference curves on said common charge scale; and
e) thereafter, based on the first and second reference curves, determining remaining capacity as the difference in charge on said common charge scale between a first predefined potential limit and a second predefined potential limit.

The present method is considerably faster compared to for example prior art methods relying on cycling of electrochemical cells or test cells, reducing the time required for diagnosis to only a fraction of the time for such prior art methods. Performing the steps of the method (one time) can typically be made in less than one minute. Furthermore, the method does not require any special measures to be taken in order to prepare the electrodes for determining open circuit potential, such as cutting samples or removing of one of layers on opposite sides of a current collector, other than extracting the electrodes from the electrochemical cell. Instead, the connection to the electrode can be made by connecting the reference electrode, via a voltmeter, to the bare part of the current collector which is already present for providing the electrical contact to the electrode when arranged in the electrochemical cell. The fact that the method is fast and does not require special measures to be taken also makes the method very cost efficient. Moreover, the fact that the method is fast and simple also enables the method to be efficiently used when desiring to investigate potential heterogeneous loss of capacity. Therefore, by using the present method, the duration for investigating the degradation and understanding the aging of the electrochemical cell may be significantly reduced. This in turn facilitates processes for development of alternative configurations of the electrochemical cell and/or control of the operation of the electrochemical cell during its intended use in an energy storage device.

According to a first alternative, said first predefined potential limit may correspond to an upper cutoff potential value of the first reference curve, and said second predefined potential limit may correspond to an upper cutoff potential value of the second reference curve. Thereby, a fast and simple method for determining remaining capacity is achieved.

According to a second alternative, the method further comprises, between step d) and step e) a step f) of determining an estimated cell voltage curve as the difference between the first reference curve and second reference curved arranged on the common charge scale. In such a case, said first predefined potential limit may correspond to a first pre-identified voltage of the electrochemical cell at a first state of charge, and the second predefined potential limit may correspond to a second pre-identified voltage of the electrochemical cell at a second state of charge. Thereby, a more accurate determination of remaining capacity may be achieved. This is due to the second alternative of the herein described method more appropriately corresponding to how state of charge is determined on cell level.

Irrespective of which of the first and second alternatives given above is utilized, the first open circuit potential is determined at a first location on the positive electrode, and the second open circuit potential is determined at a second location of the negative electrode. Said first and second locations may correspond to a common region of the positive electrode and negative electrode within the electrochemical cell before extraction of the positive and negative electrodes. Thereby, it is ensured that the diagnosis is performed for a specific region within the electrochemical cell.

The first reference curve may be a first scaled reference curve which has been scaled relative to a reference curve for the positive electrode of an undegraded electrochemical cell to account for estimated or predetermined loss of active material in the electrochemical cell. Similarly, said second reference curve may be a second scaled reference curve which has been scaled relative to a reference curve for the negative electrode of an undegraded electrochemical cell to account for estimated or predetermined loss of active material in the electrochemical cell. Thereby, a more reliable diagnosis of loss of capacity due to loss of cyclable material may be achieved since it also takes into account the estimated or predetermined loss of active material in the electrochemical cell.

As mentioned above, the open circuit potential for the positive electrode and the open circuit potential for the negative electrode are determined when the electrodes have been extracted from the electrochemical cell. The positive and the negative electrodes may suitable have been extracted from the electrochemical cell after the electrochemical cell has been fully discharged. Extracting the electrodes from a non-discharged cell may present a safety risk.

The predetermined first and second reference curves may each be determined (in advance of the herein described method) through measurement of open circuit potential relative to the preselected potential scale as a function of charge of an electrode of an undegraded electrochemical cell having the same configuration as the electrochemical cell which is diagnosed, and optionally followed by scaling to account for an estimated or predetermined loss of active material. By determining the first and second reference curves from an undegraded cell having the same configuration as the electrochemical cell which is to be diagnosed after use, the accuracy of the first and second reference curves is improved and consequently also the result of the diagnosis of the electrochemical cell. Furthermore, scaling to account for loss of active material further increases the accuracy.

The method may further comprise determining a distribution of remaining capacity throughout the electrochemical cell by repeating steps a) to e) (and step f), if present) for a plurality of locations on the positive and negative electrodes corresponding to different regions within the electrochemical cell. Thereby, it is possible to determine heterogenous degradation of the electrochemical cell quickly. Since degradation reactions can be distributed unevenly throughout the electrochemical cell, because of uneven pressure, temperature, impedance, current distribution, etc., there will inevitably be a distribution in loss of capacity within the cell. Understanding this distribution is important for understanding the effect of cell or module design on energy storage device performance degradation, which informs the limitations on usage of these components as well as future modification of the configuration of the electrochemical cell.

In step a) of the herein described method, the first open cell potential and the second open cell potential are determined without assembling samples of the positive and negative electrodes to a test cell. Thereby, the present method is considerably faster than the previously known method of assembling and cycling miniature test cells. The present method for degradation diagnosis does not involve any cycling of the electrodes.

The reference electrode used in the herein described method may comprise a porous separator configured to be wetted with an electrolyte and arranged so that a surface of the porous separator forms a distal end of the reference electrode, said distal end intended to be in contact with a sample electrode when the reference electrode is in use. The reference electrode may further comprise one or more reference electrode materials arranged at a distance from the distal end and in direct contact with the porous separator. Said one or more reference electrode materials are selected to provide a reference potential of the preselected potential scale. The reference electrode may further comprise a proximal end configured to be connected to a circuit connected to a sample electrode, and a contact configured to provide electrical connection between the one or more reference electrode materials and the proximal end.

The surface of the porous separator of the reference electrode forming the distal end may have an area which is less than 5 %, or less than 0.5 %, of the area of one side of any one of the positive electrode and the negative electrode. Thereby, the open circuit potential determined by usage of the reference electrode is determined for a relatively small surface of the respective electrodes. This in turn improves the possibility for determining a heterogenous distribution of remaining capacity throughout the electrochemical cell.

The method described herein may be performed by a control device. Thereby, the method is automated which may in turn reduce the duration of the method. Furthermore, this may increase the accuracy in the performance of the method, such as in the selection of the location on the electrodes at which the open circuit potential is determined, and thereby result in a more reliable diagnosis.

In case the method is not entirely performed by a control device, the reference electrode may be a manually operated reference electrode.

The electrochemical cell on which the present method for degradation diagnosis is performed may be a lithium-ion cell. Energy storage devices comprising lithium-ion cells are currently the most frequently used energy storage devices in the automotive industry for powering a propulsion unit (electrical machine) of a vehicle.

In case the electrochemical cell is a lithium-ion cell, the preselected potential scale may for example be any potential scale selected from the group consisting of the Li/Li+ scale, the LiFePO₄/FePO₄ scale, the Li₇Ti₅O₁₂/Li₄Ti₅O₁₂ scale, and the LiMn₂O₄/Li₂Mn₂O₄ scale.

### BRIEF DESCRIPTION OF DRAWINGS

- Fig. 1: illustrates a perspective view of an example of a vehicle,
- Fig. 2: schematically illustrates a cross sectional view of one example of an electrochemical cell of an energy storage device,
- Fig. 3: represents a flowchart schematically illustrating one exemplifying embodiment of the herein described method for degradation diagnosis of an electrochemical cell,
- Fig. 4: schematically illustrates a cross-sectional view of one exemplifying embodiment of a reference electrode that may be used in the herein described method for degradation diagnosis,
- Fig. 5: schematically illustrates a set up for determining open circuit potential for a positive electrode by usage of the reference electrode illustrated in Fig. 4,
- Fig. 6: schematically illustrates a first reference curve of open circuit potential, relative to a preselected potential scale, as a function of charge for a positive electrode of the electrochemical cell, and a second reference curve of open circuit potential, relative to a preselected potential scale, as a function of charge for a negative electrode of the electrochemical cell,
- Fig. 7: schematically illustrates the first reference curve and the second reference curve when these are arranged on a common charge scale so that the obtained first charge value Q1 and the obtained second charge value Q2 are equal,
- Fig. 8: schematically illustrates the first reference curve and the second reference curve when these are arranged on a common charge scale so that the obtained first charge value Q1 and the obtained second charge value Q2 are equal, as well as an estimated cell voltage curve of the degraded electrochemical cell.

### DETAILED DESCRIPTION

The invention will be described in more detail below with reference to exemplifying embodiments and the accompanying drawings. The invention is however not limited to the exemplifying embodiments discussed and/or shown in the drawings, but may be varied within the scope of the appended claims. Furthermore, the drawings shall not be considered drawn to scale as some features may be exaggerated in order to more clearly illustrate the invention or features thereof.

In the present disclosure, the word "curve" is used in conjunction with the terms "first reference curve" and "second reference curve", as well as the term "estimated cell voltage curve". The word "curve" is here used to describe a set of data points, such data points belonging to common basic conditions (such as specific electrode and reference scale), and which set of data points may be graphically presented in a coordinate system in the form of a curve. For the method described herein, such a coordinate system is defined by potential (or voltage) vs. charge. The word "curve" is however not intended to be limited to such a set of data points actually being presented graphically as a curve. The word "curve" should therefore in the present disclosure be interpreted broadly, and also encompasses a set of discrete data points belonging to common basic conditions (such as specific electrode and reference scale).

In accordance with the present disclosure, a method for degradation diagnosis of an electrochemical cell is provided. The electrochemical cell may for example be a lithium-ion cell, but is not limited thereto. The herein described method may be used on any type of electrochemical cell where both of the electrodes have a non-constant open circuit potential as a function of charge, which open circuit potential can be measured with a suitable reference. Lithium-ion cells are however the most frequently used electrochemical cells in energy storage devices of vehicles today. Other examples of electrochemical cells which may be diagnosed by usage of the herein described method include sodium-ion electrochemical cells, potassium-ion electrochemical cells, or magnesium-ion electrochemical cells.

The herein described method is a post-mortem method, which means that it is practiced after a period of operation of the electrochemical cell during which the electrochemical cell has been cycled (charged and discharged) multiple times such that the electrochemical cell may be subjected to aging. The method may for example be performed when it is considered that the electrochemical cell or an energy storage device comprising the electrochemical cell have reached their end of life (service life). The method needs however not be performed at the end of life of the electrochemical cell or an energy storage device comprising the electrochemical cell, but may be performed at any point in time at which it may be desired to perform a degradation diagnosis. It should however be recognized that the herein described method relies on the electrodes of the electrochemical cell being extracted from the electrochemical cell, and thus that the electrochemical cell is disassembled before the method is performed. Therefore, the herein described method constitutes a post-mortem degradation diagnosis method, even if not performed at the end of life of the electrochemical cell or an energy storage device comprising the electrochemical cell.

The herein described method for degradation diagnosis of an electrochemical cell comprises the following steps:
a) by usage of a reference electrode, determining a first (local) open circuit potential, relative to a preselected potential scale, for a positive electrode extracted from the electrochemical cell and determining a second (local) open circuit potential, relative to the preselected potential scale, for a negative electrode extracted from the electrochemical cell;
b) obtaining a first charge value by comparing the determined first open circuit potential to a first reference curve of open circuit potential, relative to the preselected potential scale, as a function of charge for the positive electrode;
c) obtaining a second charge value by comparing the determined second open circuit potential to a second reference curve of open circuit potential, relative to the preselected potential scale, as a function of charge for the negative electrode;
d) arranging the first reference curve and the second reference curve on a common charge scale so that the obtained first charge value and the obtained second charge value are equal for the first and second reference curves on said common charge scale; and
e) thereafter, based on the first and second reference curves, determining (local) remaining capacity as the difference in charge on said common charge scale between a first predefined potential limit and a second predefined potential limit.

The above mentioned first reference curve of open circuit potential, relative to the preselected potential scale, as a function of charge for the positive electrode may be determined in advance of the performance of the herein described method for degradation diagnosis of an electrochemical cell. This may be achieved through measurement of open circuit potential relative to the preselected potential scale as a function of charge of the positive electrode of an undegraded electrochemical cell having the same configuration as the electrochemical cell which is to be diagnosed, thereby obtaining a first primary reference curve of open circuit potential, relative to the preselected potential scale, as a function of charge for the positive electrode. Said first primary reference curve may thereafter be used as the first reference curve. However, the first primary reference curve of open circuit potential, relative to the preselected potential scale, as a function of charge for the positive electrode is suitably scaled to scaled to account for an estimated or predetermined loss of active material. Thus, the first refence curve may suitably be a first scaled reference curve which has been scaled relative to a reference curve for the positive electrode of an undegraded electrochemical cell to account for estimated or predetermined loss of active material in the electrochemical cell.

Moreover, the above mentioned second reference curve of open circuit potential, relative to the preselected potential scale, as a function of charge for the negative electrode may be determined in advance of the performance of the herein described method for degradation diagnosis of an electrochemical cell. This may be achieved through measurement of open circuit potential relative to the preselected potential scale as a function of charge of the negative electrode of an undegraded electrochemical cell having the same configuration as the electrochemical cell which is to be diagnosed, thereby obtaining a second primary reference curve of open circuit potential, relative to the preselected potential scale, as a function of charge for the negative electrode. Said second primary reference curve may thereafter be used as the second reference curve. However, the second primary reference curve of open circuit potential, relative to the preselected potential scale, as a function of charge for the negative electrode is suitably scaled to scaled to account for an estimated or predetermined loss of active material. Thus, the second refence curve may suitably be a second scaled reference curve which has been scaled relative to a reference curve for the negative electrode of an undegraded electrochemical cell to account for estimated or predetermined loss of active material in the electrochemical cell.

It should here be noted that the estimation or determination of loss of active material in the electrochemical cell may be performed in any previously known manner therefore, and will therefore not be described in further detail herein. For example, the average loss of active material in an electrochemical cell may be predetermined by differential voltage analysis of the cell prior to disassembly of the cell, or conventional capacity analysis such as low current rate measurement of discharge capacity of selected and representative extracted electrodes.

As evident from the above, the first and second open circuit potentials are determined for the positive and negative electrodes when these have been extracted from the electrochemical cell. This means that the electrochemical cell is disassembled before the conduct of the herein described method for degradation diagnosis of the electrochemical cell. More specifically, the positive and negative electrodes may suitably each be extracted from the electrochemical cell as electrode sheets. Such electrode sheets comprises both the electrode per se and the current collector connected thereto. The electrode sheets are suitably maintained in the conduct of the present method since the current collector thereof provides a suitable connection between the reference electrode, via a voltmeter, to the electrode of the electrode sheet. In fact, the reference electrode may, via the voltmeter, be connected to the bare portion of the current collector which is present for allowing connection thereto when arranged in the electrochemical cell.

The extraction of the positive and negative electrodes of the electrochemical cell as described above may suitably be performed when the electrochemical cell has been essentially fully discharged, although it is also to perform the present method for degradation diagnosis in case the electrodes have been extracted when the electrochemical cell is partly or fully charged. Safe extraction of the positive and negative electrodes is however much easier in case of the electrochemical cell being fully discharged before the extraction. It should here be noted that the term "fully discharged" is used the purpose of pointing out that the electrochemical cell has been discharged with the goal to achieve a fully discharged state. However, in practice, a completely fully discharged state may be difficult to reach. Thus, the term "fully discharged" should be interpreted broadly in the present disclosure.

The first open circuit potential is determined at a first location on the positive electrode, and the second open circuit potential is determined at a second location of the negative electrode. Said first and second locations should ideally correspond to each other, i.e. should be locations on the electrodes which, before extraction of the electrodes from the electrochemical cell, were arranged so as to oppose each other (arranged on opposite sides of a common separator). However, in practice is may be quite difficult to ensure that the second position on the negative electrode exactly matches the first position on the positive electrode, especially in case the electrodes were in wound form in the electrochemical cell. Also, the electrodes may have, due to the aging of the electrochemical cell, moved slightly in relation to each other during operation of the electrochemical cell. Therefore, it is more accurate to aim for determining the open circuit potential of the respective electrodes at locations on the respective electrodes that correspond to a common region of the positive electrode and negative electrode within the electrochemical cell before these electrodes were extracted from the electrochemical cell.

It is previously known that degradation reactions can be distributed unevenly throughout the electrochemical cell. This can be due to several factors including uneven pressure, temperature, impedance, current distribution, etc. Thus, there will inevitably be a heterogenous distribution in loss of capacity within the electrochemical cell. Understanding this distribution is very important for understanding the effect of cell or module design on energy storage device performance degradation. Understanding the distribution increases the knowledge of limitations on the usage of the electrochemical cell as well as the energy storage device comprising the electrochemical cell. Furthermore, knowledge of the distribution also facilitates development of alternative configurations of the electrochemical cell and/or the energy storage device comprising the electrochemical cell.

The herein described method for degradation diagnosis provides unprecedented advantages for examining such a heterogenous distribution of loss of capacity. This is mainly due to the ability to quickly determine a local loss of capacity within an identified region of the electrochemical cell by performing the above described steps a) - e). Simply repeating the steps of the method at multiple identified regions of the electrochemical cell inherently results in obtaining information regarding the distribution of remaining capacity (and thus also loss of capacity). Prior art methods relying for example of assembling and cycling of miniature test cells would require considerable efforts and be very time consuming if seeking to obtain information regarding distribution of remaining capacity of a degraded electrochemical cell, and therefore be very costly. In contrast, the present method may easily and quickly be performed at a large number of locations on the respective electrodes by simply moving the reference electrode used between the different locations on the respective electrodes and determine the local remaining capacity for each of the regions corresponding to said locations. Therefore, the herein described method provides a much more realistic tool, both in terms of time and cost, when desiring to assess the distribution of remaining capacity of a degraded electrochemical cell.

The method for degradation diagnosis as described herein may be performed by a control device configured therefore. The control device may be configured to perform any one of the steps of the method as described herein. More specifically, the control device may be configured to determine the first open circuit potential for the positive electrode as well as determine the second open circuit potential for the negative electrode by usage of a reference electrode. The control device may thus be configured to control the reference electrode, more specifically control the positioning of the reference electrode for the purpose of determining the respective open circuit potentials for the electrodes.

The performance of the method for degradation diagnosis as disclosed herein may be governed by programmed instructions. These programmed instructions typically take the form of a computer program which, when executed in or by a control device, causes the control device to effect desired forms of control action. Such instructions may typically be stored on a computer-readable medium.

Thus, the present disclosure further provides a computer program comprising instructions for degradation diagnosis of an electrochemical cell. The computer program comprises instructions for by usage of a reference electrode, determining a first open circuit potential, relative to a preselected potential scale, for a positive electrode extracted from the electrochemical cell and determining a second open circuit potential, relative to the preselected potential scale, for a negative electrode extracted from the electrochemical cell. The computer program further comprises instructions for obtaining a first charge value by comparing the determined first open circuit potential to a first reference curve of open circuit potential, relative to the preselected potential scale, as a function of charge for the positive electrode. The computer program also comprises instructions for obtaining a second charge value by comparing the determined second open circuit potential to a second reference curve of open circuit potential, relative to the preselected potential scale, as a function of charge for the negative electrode. Moreover, the computer program comprises instructions for arranging the first reference curve and the second reference curve on a common charge scale so that the obtained first charge value and the obtained second charge value are equal for the first and second reference curves on said common charge scale. The computer program also comprises instructions for, based on the first and second reference curves, determining remaining capacity as the difference in charge on said common charge scale between a first predefined potential limit and a second predefined potential limit.

It should also be noted that the method may be performed purely manually or only partly through use of a control device and/or computer program. For example, the reference electrode may be a manually operated reference electrode. The present disclosure is thus not limited to the method being performed solely of the control device described above.

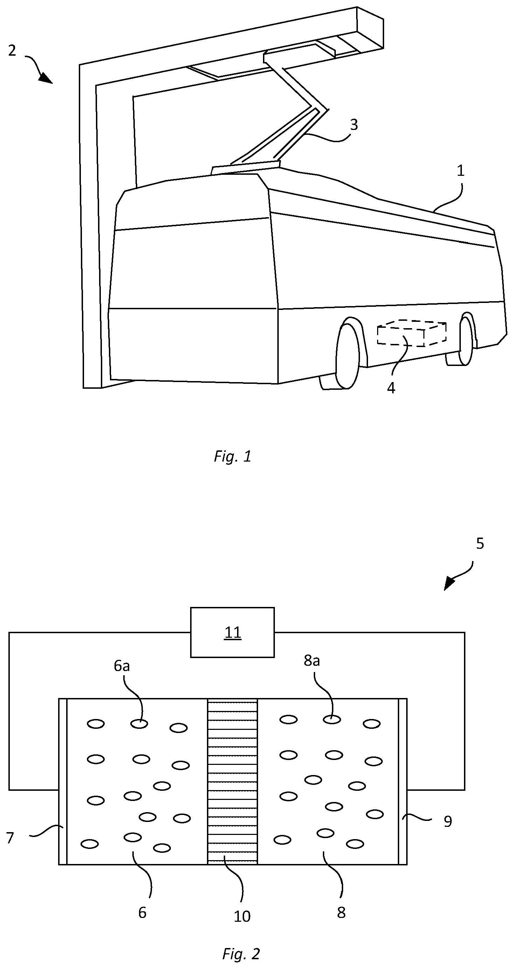

Figure 1 illustrates an example of a vehicle 1, here shown as a bus, present at a charging station 2. The vehicle may comprise a current collector, here illustrated as being in the form of a pantograph 3, configured to allow the vehicle 1 to be connected to the charging station 2 for the purpose of charging an energy storage device 4 (schematically illustrated in the figure by dashed lines) onboard the vehicle 1. An energy storage device 4 of a vehicle 1 may in general comprise a large number of individual electrochemical cells, such as lithium-ion electrochemical cells. The electrochemical cells may be arranged in a plurality of batteries, which in turn may be arranged in a plurality of battery packs.

Figure 2 schematically illustrates a cross sectional view of one example of an electrochemical cell 5, such as an electrochemical cell 5 of an energy storage device 4 of the vehicle 1 shown in figure 1. The electrochemical cell 2 comprises a negative electrode 6 connected to a first current collector 7. The negative electrode 6 and the first current collector 7 together form a first electrode sheet. The negative electrode 6 may be formed of a porous structure of a first electroactive material 6a, such as a carbonaceous material. The electrochemical cell 2 further comprises a positive electrode 8 connected to a second current collector 9. The positive electrode 8 and the second current collector 9 together form a second electrode sheet. The positive electrode 8 may be formed of a porous structure of a second electroactive material 8a, such as a lithium ion containing material. A separator 10 is interposed between the negative electrode 6 and the positive electrode 8. The electrochemical cell 5 further comprises an electrolyte (not shown). The electrolyte may be present within the porous structures of the negative electrode 6 and the positive electrode 8, as well as the separator 10. The first and second current collectors 7, 9 may in turn be connected to a load (during discharging) or charger (during charging). The load/charger is schematically illustrated in Figure 2 by the box 11.

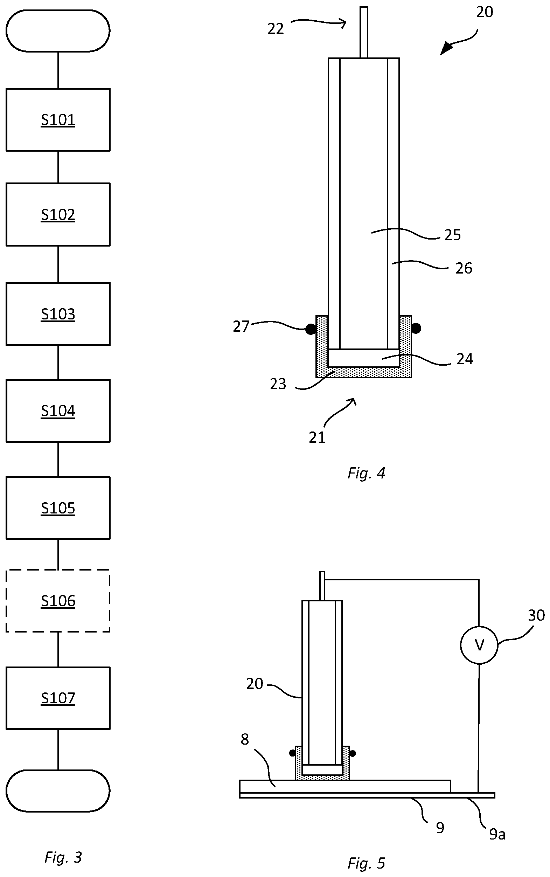

Figure 3 represents a flowchart schematically illustrating one exemplifying embodiment of the herein described method for degradation diagnosis of an electrochemical cell.

The method comprises a step S101 of determining a first open circuit potential, relative to a preselected potential scale, for a positive electrode extracted from the electrochemical cell. The determination of said first open circuit potential is performed by usage of a reference electrode. The first open circuit potential may be determined at a first location on the positive electrode.

The method also comprises a step S102 of determining a second open circuit potential, relative to the preselected potential scale, for a negative electrode extracted from the electrochemical cell. The determination of said second open circuit potential is performed by usage of a reference electrode, suitably the same reference electrode as used in step S101 or at least a reference electrode having the same configuration as the reference electrode used in step S101. The second open circuit potential may be determined at a second location on the negative electrode. Said second location preferably corresponds to a location on the negative electrode which, before the electrodes were extracted from the electrochemical cell, was arranged so as to face the first location on the positive electrode. In other words, the second location on the negative electrode should preferably match the first location on the positive electrode. It should however be noted that in practice, it may be difficult to ensure the second position on the negative electrode exactly matches the corresponding (opposing) first position on the positive electrode. Therefore, it is more accurate to state that the first and second locations should preferably correspond to a common region of the positive electrode and negative electrode within the electrochemical cell before extraction of the positive and negative electrodes.

The method further comprises a step S103 of obtaining a first charge value by comparing the determined first open circuit potential (obtained in step S101) to a first reference curve of open circuit potential, relative to the preselected potential scale, as a function of charge for the positive electrode. In practice, the first charge value is obtained by determining a charge which corresponds to the determined first open circuit potential from the first reference curve. Said first reference curve is obtained in advance, i.e. before the herein described method is performed. Said first reference curve may for example be determined through measurement of open potential circuit relative to the preselected potential scale as a function of charge of the positive electrode of an undegraded electrochemical cell (i.e. an electrochemical cell that has not been cycled or only cycled a few times) having the same configuration as the electrochemical cell which is diagnosed by the herein described method. Suitably, the measured open circuit potential of the positive electrode of the undegraded electrochemical cell is thereafter scaled to account for an estimated or predetermined loss of active material, thereby arriving at the first reference curve.

The method further comprises a step S104 of obtaining a second charge value by comparing the determined second open circuit potential (obtained in step S102) to a second reference curve of open circuit potential, relative to the preselected potential scale, as a function of charge for the negative electrode. Said second reference curve is obtained in advance and may be determined through measurement of open potential circuit relative to the preselected potential scale as a function of charge of the negative electrode of an undegraded electrochemical cell, and thereafter suitably scaled to account for an estimated or predetermined loss of active material.

It should here be noted that although steps S101 to S104 are shown in a particular order in the figure, said steps may naturally be performed in any order as long as step S102 is performed after S101 and step S104 is performed after step S102. Also, steps S101 and S102 may be performed in parallel, and/or steps S103 and S104 may be performed in parallel.

The method further comprises a step S105 of arranging the first reference curve and the second reference curve on a common charge scale such that the first charge value (obtained in step S103) and the second charge value (obtained in step S104) are equal for the first and second reference curves on said common charge scale.

The method may, after step S105, optionally comprise a step S106 of determining an estimated cell voltage curve as the difference between the first reference curve and the second reference curve arranged on the common charge scale (as obtained in step S105).

Furthermore, the method comprises, after step S105, a step S107 of determining remaining capacity as the difference in charge on said common charge scale between a first predefined potential limit and a second predefined potential limit. In case the method does not comprise the optional step S106, the first predefined potential limit may correspond to the upper cutoff potential value of the first reference curve and the second predefined potential limit may correspond to the upper cutoff potential value of the second reference curve. However, in case the method comprises the optional step S106, the remining capacity is determined from the estimated cell voltage curve (which in turn is determined based on the first and second reference curves) as the difference in charge on said common charge scale between a first predefined potential limit and a second predefined potential limit. In the latter case, the first predefined potential limit corresponds to a first pre-identified voltage of the electrochemical cell at a first state of charge, and the second predefined potential limit corresponds to a second pre-identified voltage of the electrochemical cell at a second state of charge. Said first and second pre-identified voltages of the electrochemical cell are obtained in advance, and preferably from an undegraded electrochemical cell. The first state of charge and the second state of charge may for example be 0% SOC and 100% SOC, respectively, or any state of charge limits between which the electrochemical cell was configured to be cycled.

In case there is a desire to determine the distribution of remaining capacity throughout a portion or the entire electrochemical cell, the above-described steps S101-S107 of the method may be repeated for other locations on the positive and negative electrodes.

Figure 4 schematically illustrates a cross-sectional view of one exemplifying embodiment of a reference electrode 20 that may be used in the herein described method for degradation diagnosis. The reference electrode 20 has a distal end 21 and a proximal end 22. The distal end 21 of the reference electrode 20 is intended to be in contact with a sample electrode when the reference electrode is in use and the proximal end 22 is configured to be connected to a circuit connected to a sample electrode during use of the reference electrode 20.

The reference electrode 20 comprises a porous separator 23 arranged so that a surface of the porous separator forms the distal end 21 of the reference electrode 21. Said surface of the porous separator forming the distal end 21 may suitably have an area which is considerably smaller than the surface area of the respective sample electrodes (i.e. the positive and negative electrodes of the electrochemical cell which is diagnosed by the herein described method). The surface of the porous separator of the reference electrode forming the distal end may have an area which is less than 5 %, or less than 0.5 %, of the area of one side of any one of the positive electrode and the negative electrode. The surface of the porous separator forming the distal end may for example have an area which is about 2 cm² or less, suitably about 1 cm² or less (such as about 0.5 cm²). The porous separator is, during use of the reference electrode, wetted with an electrolyte (not shown). Thus, the porous separator 23 is configured to be wetted with an electrolyte. The porous separator 23 may for example be made of glass fiber, but is not limited thereto. The electrolyte may for example be any electrolyte which is used in an electrochemical cell.

The reference electrode 20 further comprises one or more reference electrode materials 24, selected to provide a reference potential of a preselected potential scale. For example, in case the preselected potential scale is the Li/Li+ scale, the one or more reference electrode materials 24 may constitute a Li metal disc. The one or more reference electrode materials 24 are, as shown in the figure, arranged at a distance from the distal end and in direct contact with the porous separator 23.

The reference electrode 20 further comprises a contact 25 configured to provide electrical connection between the one or more reference electrode materials 24 and the proximal end of the reference electrode 20. The contact may for example be formed of copper or steel. The contact 25 may suitably be protected by an electrical insulation 26 arranged around the contact 25.

Furthermore, as shown in the figure, the porous separator 23 may extend from the distal end 21 and over a portion of the electrical insulation 26 so that the one or more reference electrode materials 24 are fully enclosed in the reference electrode 20. The porous separator 23 may be held in place by an O-ring 27 or some type of other fastening means.

Figure 5 schematically illustrates a set up for determining open circuit potential for a positive electrode 8 by usage of the reference electrode 20 illustrated in Figure 4. The reference electrode 20 is held against the surface of the positive electrode 8. The positive electrode 8 is in turn arranged on a current collector, which for sake of simplicity and for minimizing the risk of damaging the positive electrode during extraction from the electrochemical cell is the current collector 9 of the same electrode sheet as the positive electrode 8. In other words, the positive electrode 8 is suitably not removed from the current collector 9 during extraction thereof from the electrochemical cell.

Furthermore, the reference electrode 20 is, via a voltmeter 30, connected to a bare portion 9a of the current collector 9. This set up will provide an ionic bridge between the reference material(s) 24 and the positive electrode 8 as well as an electronic connection forming a full circuit to gauge a potential difference which may be read by the voltmeter 30.

It should be noted that although Figure 5 illustrates a set up for determining open circuit potential for a positive electrode, a corresponding set up may naturally be used for determining open circuit potential for a negative electrode.

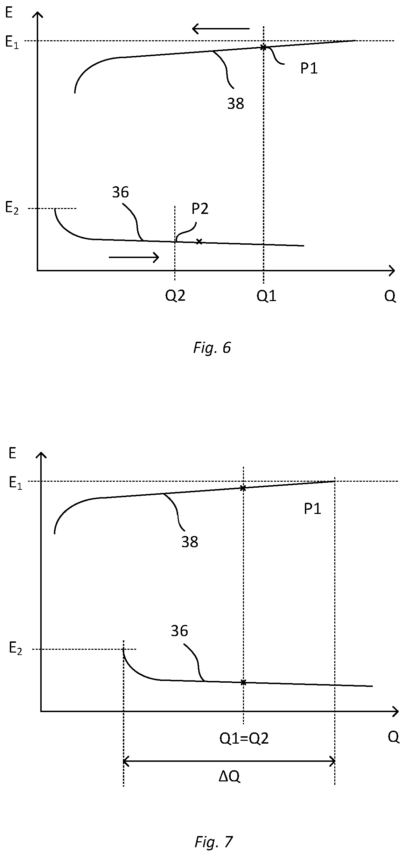

For the purpose of further demonstrating the steps of the herein described method for degradation diagnosis, Figure 6 schematically illustrates a first reference curve 38 for a positive electrode of the electrochemical cell and a second reference curve 36 for the negative electrode of the electrochemical cell, here shown in a common coordinate system for sake of illustration. Each of the reference curves 36, 38 represent open circuit potential E relative to the preselected potential scale as a function of charge Q.

The first reference curve 38 may be determined, in advance of the performance of the herein described method for degradation diagnosis, through measurement of open circuit potential relative to the preselected potential scale as a function of charge of a positive electrode of an undegraded electrochemical cell having the same configuration as the electrochemical cell which is to be diagnosed by the herein described method (i.e. a degraded electrochemical cell). Said measurement of open circuit potential for the positive electrode of the undegraded electrochemical cell results in a set of data points which may be graphically presented as a first primary reference curve of the undegraded cell. For the purpose of increasing the accuracy in the method for degradation diagnosis, said first primary reference curve may thereafter be scaled to account for an estimated or predetermined loss of active material at the positive electrode to thereby arrive at the first reference curve 38. By way of example, if the estimated or predetermined loss of active material at the point in time at which the degradation diagnosis is to be performed would be 5%, then the values of charge for the first primary reference curve are linearly scaled to 95% to thereby arrive at the first reference curve 38.

Similarly, the second reference curve 36 may be determined in advance of the performance of the herein described method for degradation diagnosis, through measurement of open circuit potential relative to the preselected potential scale as a function of charge of a negative electrode of an undegraded electrochemical cell having the same configuration as the electrochemical cell which is to be diagnosed by the herein described method. Said measurement of open circuit potential for the negative electrode of the undegraded electrochemical cell results in a set of data points which may be graphically presented as a second primary reference curve of the undegraded cell. The second primary reference curve may thereafter be scaled to account for an estimated or predetermined loss of active material at the negative electrode to thereby arrive at the second reference curve 36.

As previously described, the present method comprises determining a first open circuit potential relative to the preselected potential scale for the positive electrode (step a). The determined first open circuit potential is in the figure shown as P1. The determined first open circuit potential P1 is compared to the first reference curve 38 by determining where said first open circuit potential P₁ coincides with the first reference curve 38 as illustrated in the figure. Thereby, a first charge value Q1 is obtained from the first reference curve 38 at said determined first open circuit potential P1 (step b).

Furthermore, the present method comprises determining a second open circuit potential relative to the preselected potential scale for the negative electrode (step a). The determined second open circuit potential is in the figure shown as P2. The method comprises obtaining a second charge value Q2 by comparing the determined second open circuit potential P2 to the second reference curve 36 (step c).

The method thereafter comprises arranging the first reference curve 38 and the second reference curve on a common charge scale so that the obtained first charge value Q1 and the obtained second charge value Q2 are equal for the first and second reference curves on said common charge scale (step d). This means that the first and second reference curves 36, 38 in the illustrated figure are shifted relative each other in the direction illustrated by the arrows until Q1=Q2.

Figure 7 schematically illustrates the first and second reference curves when arranged on a common charge scale so that the obtained first charge value Q1 and the obtained second charge value Q2 are equal. The herein described method thereafter comprises, based on the first reference curve 38 and the second reference curve 36, determining remaining capacity as the difference in charge ΔQ on said common charge scale between a first predefined potential limit and a second predefined potential limit (step e). According to the first alternative of the present method, the first predefined potential limit corresponds to the upper cutoff potential value E₁ of the first reference curve 38 and the second potential limit corresponds to the upper cutoff potential value E₂ of the second reference curve 36.

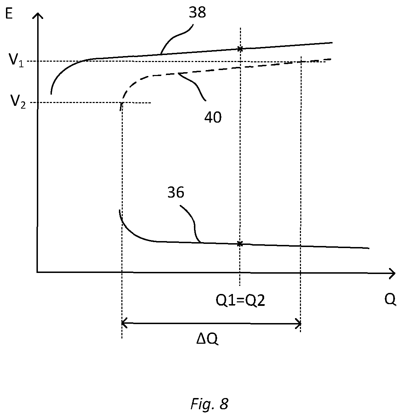

According to a second alternative of the herein described method for degradation diagnosis, the method comprises a step f) after step d) but prior to step e). Said step f) comprises determining an estimated cell voltage curve 40 as the difference between the first reference curve 38 and second reference curve 36 when these are arranged on the common charge scale so that Q1=Q2. Figure 8 schematically illustrates the first and second reference curves 38, 36 when arranged on a common charge scale so that the obtained first charge value Q1 and the obtained second charge value Q2 are equal as well as the estimated cell voltage curve 40. The estimated cell voltage curve 40 may thus be considered to correspond to the cell voltage curve of the degraded electrochemical cell and may be compared to cell voltage curve of an undegraded electrochemical cell having the same configuration as the degraded electrochemical cell or the cell voltage curve of the degraded electrochemical cell when said electrochemical cell was undegraded. More specifically, when the estimated cell voltage curve 40 has been obtained, the first predefined potential limit used in step e) of the present method may correspond to a first pre-identified voltage of the electrochemical cell at a first state of charge. Said first pre-identified voltage is in Figure 8 illustrated as V₁. Moreover, the second predefined potential limit used in step e) of the present method may correspond to a second pre-identified voltage of the electrochemical cell at a second state of charge, said second pre-identified voltage illustrated in the figure as V₂. Thus, in accordance with the second alternative of the herein described method, step e) comprises determining remaining capacity as the difference in charge (ΔQ) on the common charge scale between V₁ and V₂ as shown in Figure 8.

## Claims

1. A method for degradation diagnosis of an electrochemical cell (5), wherein the method is **characterised by** comprising
the following steps:
a) by usage of a reference electrode (20), determining (S101) a first open circuit potential (P1), relative to a preselected potential scale, for a positive electrode (8) extracted from the electrochemical cell (5) and determining (S102) a second open circuit potential (P2), relative to the preselected potential scale, for a negative electrode (6) extracted from the electrochemical cell (5);
b) obtaining (S103) a first charge value (Q1) by comparing the determined first open circuit potential (P1) to a first reference curve (38) of open circuit potential, relative to the preselected potential scale, as a function of charge for the positive electrode (8);
c) obtaining (S104) a second charge value (Q2) by comparing the determined second open circuit potential (P2) to a second reference curve (36) of open circuit potential, relative to the preselected potential scale, as a function of charge for the negative electrode (6);
d) arranging (S105) the first reference curve (38) and the second reference curve (36) on a common charge scale so that the obtained first charge value (Q1) and the obtained second charge value (Q2) are equal for the first and second reference curves (38, 36) on said common charge scale; and
e) thereafter, based on the first and second reference curves (38, 36), determining (S107) remaining capacity as the difference in charge (ΔQ) on said common charge scale between a first predefined potential limit and a second predefined potential limit.

2. The method according to claim 1, wherein said first predefined potential limit corresponds to an upper cutoff potential value (E₁) of the first reference curve (38), and said second predefined potential limit corresponds to an upper cutoff potential value (E₂) of the second reference curve (36).

3. The method according to claim 1, wherein the method further comprises, between step d) and step e),
f) determining (S106) an estimated cell voltage curve (40) as the difference between the first reference curve (38) and second reference curve (36) arranged on the common charge scale; and
wherein said first predefined potential limit corresponds to a first pre-identified voltage (V₁) of the electrochemical cell (5) at a first state of charge, and the second predefined potential limit corresponds to a second pre-identified voltage (V₂) of the electrochemical cell (5) at a second state of charge.

4. The method according to any one of the preceding claims, wherein the first open circuit potential is determined at a first location on the positive electrode (8), and the second open circuit potential is determined at a second location on the negative electrode (6), said first and second locations corresponding to a common region of the positive electrode (8) and negative electrode (6) within the electrochemical cell (5) before extraction of the positive and negative electrodes (8, 6).

5. The method according to any one of the preceding claims, wherein said first reference curve (38) is a first scaled reference curve which has been scaled relative to a reference curve for the positive electrode (8) of an undegraded electrochemical cell (5) to account for estimated or predetermined loss of active material in the electrochemical cell (5), and said second reference curve (36) is a second scaled reference curve which has been scaled relative to a reference curve for the negative electrode (6) of an undegraded electrochemical cell (5) to account for estimated or predetermined loss of active material in the electrochemical cell (5).

6. The method according to any one of the preceding claims, wherein the positive and the negative electrodes (8, 6) have been extracted from the electrochemical cell (5) after the electrochemical cell (5) has been fully discharged.

7. The method according to any one of the preceding claims, wherein said predetermined first and second reference curves (38, 36) each are determined through measurement of open circuit potential relative to the preselected potential scale as a function of charge of an electrode of an undegraded electrochemical cell (5) having the same configuration as the electrochemical cell (5) which is diagnosed, and optionally followed by scaling to account for an estimated or predetermined loss of active material.

8. The method according to any one of the preceding claims, further comprising determining a distribution of remaining capacity throughout the electrochemical cell (5) by repeating steps a) to e) for a plurality of locations on the positive and negative electrodes (8, 6) corresponding to different regions within the electrochemical cell (5).

9. The method according to any one of the preceding claims, wherein the first open cell potential and the second open cell potential are determined without assembling samples of the positive and negative electrodes (8, 6) to a test cell.

10. The method according to any one of the preceding claims, wherein the reference electrode (20) comprises:
a porous separator (23) configured to be wetted with an electrolyte and arranged so that a surface of the porous separator (23) forms a distal end (21) of the reference electrode (20), said distal end (21) intended to be in contact with a sample electrode when the reference electrode (20) is in use,
one or more reference electrode materials (24), selected to provide a reference potential of the preselected potential scale, arranged at a distance from the distal end (21) and in direct contact with the porous separator (23),
a proximal end (22) configured to be connected to a circuit connected to a sample electrode, and
a contact (25) configured to provide electrical connection between the one or more reference electrode materials (24) and the proximal end (22).

11. The method according to claim 10, wherein the surface of the porous separator (23) forming the distal end (21) has an area which is less than 5 %, or less than 0.5 %, of the area of one side of any one of the positive electrode (8) and the negative electrode (6).

12. The method according to any one of the preceding claims, wherein the method is performed by a control device.

13. The method according to any one of claims 1-11, wherein the reference electrode (20) is a manually operated reference electrode (20).

14. The method according to any one of the preceding claims, wherein the electrochemical cell (5) is a lithium-ion cell.

15. The method according to claim 14, wherein the preselected potential scale is a potential scale selected from the group consisting of Li/Li+ scale, LiFePO₄/FePO₄ scale, Li₇Ti₅O₁₂/Li₄Ti₅O₁₂ scale, and LiMn₂O₄/Li₂Mn₂O₄ scale.

## Patentansprüche

1. Verfahren zur Diagnose des Abbaus einer elektrochemischen Zelle (5), wobei das Verfahren **dadurch gekennzeichnet ist, dass** es die folgenden Schritte umfasst:
a) durch Verwendung einer Referenzelektrode (20), Bestimmen (S101) eines ersten Leerlaufpotentials (P1) relativ zu einer vorab ausgewählten Potentialskala für eine positive Elektrode (8), die der elektrochemischen Zelle (5) entnommen wird, und Bestimmen (S102) eines zweiten Leerlaufpotentials (P2) relativ zu der vorab ausgewählten Potentialskala für eine negative Elektrode (6), die der elektrochemischen Zelle (5) entnommen wird;
b) Erhalten (S103) eines ersten Ladungswerts (Q1) durch Vergleichen des bestimmten ersten Leerlaufpotentials (P1) mit einer ersten Referenzkurve (38) des Leerlaufpotentials relativ zu der vorab ausgewählten Potentialskala als eine Funktion der Ladung für die positive Elektrode (8);
c) Erhalten (S104) eines zweiten Ladungswerts (Q2) durch Vergleichen des bestimmten zweiten Leerlaufpotentials (P2) mit einer zweiten Referenzkurve (36) des Leerlaufpotentials relativ zu der vorab ausgewählten Potentialskala als eine Funktion der Ladung für die negative Elektrode (6);
d) Anordnen (S105) der ersten Referenzkurve (38) und der zweiten Referenzkurve (36) auf einer gemeinsamen Ladungsskala, sodass der erhaltene erste Ladungswert (Q1) und der erhaltene zweite Ladungswert (Q2) für die erste und zweite Referenzkurve (38, 36) auf der gemeinsamen Ladungsskala gleich sind; und
e) anschließendes Bestimmen (S107) der verbleibenden Kapazität als Ladungsdifferenz (ΔQ) auf der gemeinsamen Ladungsskala zwischen einem ersten vordefinierten Potenzialgrenzwert und einem zweiten vordefinierten Potenzialgrenzwert basierend auf der ersten und zweiten Referenzkurve (38, 36).

2. Verfahren nach Anspruch 1, wobei der erste vordefinierte Potenzialgrenzwert einem oberen Abschaltpotenzialwert (E₁) der ersten Referenzkurve (38) entspricht, und der zweite vordefinierte Potenzialgrenzwert einem oberen Abschaltpotenzialwert (E₂) der zweiten Referenzkurve (36) entspricht

3. Verfahren nach Anspruch 1, wobei das Verfahren zwischen Schritt d) und Schritt e) ferner Folgendes umfasst:
f) Bestimmen (S106) einer geschätzten Zellspannungskurve (40) als Differenz zwischen der ersten Referenzkurve (38) und der zweiten Referenzkurve (36), die auf der gemeinsamen Ladungsskala angeordnet sind; und
wobei der erste vordefinierte Potenzialgrenzwert einer ersten vorab identifizierten Spannung (V₁) der elektrochemischen Zelle (5) bei einem ersten Ladezustand entspricht, und der zweite vordefinierte Potenzialgrenzwert einer zweiten vorab identifizierten Spannung (V₂) der elektrochemischen Zelle (5) bei einem zweiten Ladezustand entspricht.

4. Verfahren nach einem der vorangehenden Ansprüche, wobei das erste Leerlaufpotential an einer ersten Stelle auf der positiven Elektrode (8) bestimmt wird und das zweite Leerlaufpotential an einer zweiten Stelle auf der negativen Elektrode (6) bestimmt wird, wobei die erste und zweite Stelle mit einem gemeinsamen Bereich auf der positiven Elektrode (8) und der negativen Elektrode (6) in der elektrochemischen Zelle (5) vor der Entnahme der positiven und negativen Elektroden (8, 6) übereinstimmen.

5. Verfahren nach einem der vorangehenden Ansprüche, wobei die erste Referenzkurve (38) eine erste skalierte Referenzkurve ist, die relativ zu einer Referenzkurve für die positive Elektrode (8) einer nicht degradierten elektrochemischen Zelle (5) skaliert ist, um einen geschätzten oder vorbestimmten Verlust von aktivem Material in der elektrochemischen Zelle (5) zu berücksichtigen, und wobei die zweite Referenzkurve (36) eine zweite skalierte Referenzkurve ist, die relativ zu einer Referenzkurve für die negative Elektrode (6) einer nicht degradierten elektrochemischen Zelle (5) skaliert ist, um einen geschätzten oder vorbestimmten Verlust von aktivem Material in der elektrochemischen Zelle (5) zu berücksichtigen.

6. Verfahren nach einem der vorangehenden Ansprüche, wobei die positiven und negativen Elektroden (8, 6) aus der elektrochemischen Zelle (5) entnommen wurden, nachdem die elektrochemische Zelle (5) vollständig entladen wurde.

7. Verfahren nach einem der vorangehenden Ansprüche, wobei die vorab festgelegten ersten und zweiten Referenzkurven (38, 36) jeweils durch Messung des Leerlaufpotenzials relativ zu der vorab ausgewählten Potenzialskala als Funktion der Ladung einer Elektrode einer nicht degradierten elektrochemischen Zelle (5) bestimmt werden, die dieselbe Konfiguration wie die zu diagnostizierende elektrochemische Zelle (5) aufweist, und optional gefolgt von einer Skalierung, um einen geschätzten oder vorab festgelegten Verlust an aktivem Material zu berücksichtigen.

8. Verfahren nach einem der vorangehenden Ansprüche, ferner umfassend Bestimmen einer Verteilung der verbleibenden Kapazität in der elektrochemischen Zelle (5) durch Wiederholen der Schritte a) bis e) für eine Mehrzahl von Stellen auf den positiven und negativen Elektroden (8, 6), die verschiedenen Regionen in der elektrochemischen Zelle (5) entsprechen.

9. Verfahren nach einem der vorangehenden Ansprüche, wobei das erste offene Zellpotential und das zweite offene Zellpotential ohne das Zusammensetzen von Proben der positiven und negativen Elektroden (8, 6) zu einer Testzelle bestimmt werden.

10. Verfahren nach einem der vorangehenden Ansprüche, wobei die Referenzelektrode (20) Folgendes umfasst:
einen porösen Separator (23), der dazu eingerichtet ist, mit einem Elektrolyt befeuchtet und so angeordnet zu werden, dass eine Oberfläche des porösen Separators (23) ein distales Ende (21) der Referenzelektrode (20) bildet, wobei das distale Ende (21) mit der Probeelektrode in Kontakt stehen soll, wenn sich die Referenzelektrode (20) in Benutzung befindet,
ein oder mehrere Referenzelektrodenmaterialien (24), die ausgewählt wurden, um ein Referenzpotential der vorab ausgewählten Potentialskala bereit zu stellen, die in einer Entfernung von dem distalen Ende (21) und in direktem Kontakt mit dem porösen Separator (23) angeordnet ist,
ein proximales Ende (22), das dazu eingerichtet ist, mit einer Schaltung in Verbindung zu stehen, die mit einer Probeelektrode in Verbindung steht und
einen Kontakt (25), der dazu eingerichtet ist, eine elektrische Verbindung zwischen einem oder mehreren Referenzelektrodenmaterialien (24) und dem proximalen Ende (22) bereitzustellen.

11. Verfahren nach Anspruch 10, wobei die Oberfläche des porösen Separators (23), die ein distales Ende (21) bildet, einen Bereich aufweist, der weniger als 5% oder weniger als 0,5% des Bereichs einer Seite jeder von positiver Elektrode (8) und negativer Elektrode (6) ist.

12. Verfahren nach einem der vorangehenden Ansprüche, wobei das Verfahren von einer Steuervorrichtung ausgeführt wird.

13. Verfahren nach einem der Ansprüche 1-11, wobei die Referenzelektrode (20) eine manuell betriebene Referenzelektrode (20) ist.

14. Verfahren nach einem der vorangehenden Ansprüche, wobei die elektrochemische Zelle (5) eine Lithium-Ionen-Zelle ist.

15. Verfahren nach Anspruch 14, wobei die vorgewählte potentielle Skala eine potentielle Skala ist, die aus einer Gruppe ausgewählt wird, die aus einer Li/Li+-Skala, einer LiFePO₄/FePO₄-Skala, einer Li₇Ti₅O₁₂/Li₄Ti₅O₁₂-Skala und einer LiMn₂O₄/Li₂Mn₂O₄-Skala besteht.

## Revendications

1. L'invention concerne un procédé de diagnostic de dégradation d'une cellule électrochimique (5), ledit procédé étant **caractérisé en ce qu'**il comprend
les étapes suivantes :
a) l'utilisation d'une électrode de référence (20), la détermination (S101) d'un premier potentiel de circuit ouvert (P1), par rapport à une échelle de potentiel présélectionnée, pour une électrode positive (8) extraite de la cellule électrochimique (5) et la détermination (S102) d'un deuxième potentiel de circuit ouvert (P2), par rapport à l'échelle de potentiel présélectionnée, pour une électrode négative (6) extraite de la cellule électrochimique (5) ;
b) l'obtention (S103) d'une première valeur de charge (Q1) en comparant le premier potentiel de circuit ouvert déterminé (P1) à une première courbe de référence (38) de potentiel de circuit ouvert, par rapport à l'échelle de potentiel présélectionnée, en fonction de la charge pour l'électrode positive (8) ;
c) l'obtention (S104) d'une deuxième valeur de charge (Q2) en comparant le deuxième potentiel de circuit ouvert déterminé (P2) à une deuxième courbe de référence (36) de potentiel de circuit ouvert, par rapport à l'échelle de potentiel présélectionnée, en fonction de la charge pour l'électrode négative (6) ;
d) l'agencement (S105) de la première courbe de référence (38) et de la deuxième courbe de référence (36) sur une échelle de charge commune de sorte que la première valeur de charge obtenue (Q1) et la deuxième valeur de charge obtenue (Q2) sont égales pour les première et deuxième courbes de référence (38, 36) sur ladite échelle de charge commune ; et
e) ensuite, sur la base des première et deuxième courbes de référence (38, 36), la détermination (S107) de la capacité restante comme la différence de charge (ΔQ) sur ladite échelle de charge commune entre une première limite de potentiel prédéfinie et une deuxième limite de potentiel prédéfinie.

2. Procédé selon la revendication 1, dans lequel ladite première limite de potentiel prédéfinie correspond à une valeur de potentiel de coupure supérieure (E₁) de la première courbe de référence (38), et ladite deuxième limite de potentiel prédéfinie correspond à une valeur de potentiel de coupure supérieure (E₂) de la deuxième courbe de référence (36).

3. Procédé selon la revendication 1, dans lequel le procédé comprend en outre, entre l'étape d) et l'étape e) :
f) la détermination (S106) d'une courbe de tension de cellule estimée (40) comme la différence entre la première courbe de référence (38) et la deuxième courbe de référence (36) agencées sur l'échelle de charge commune ; et
dans lequel ladite première limite de potentiel prédéfinie correspond à une première tension pré-identifiée (V₁) de la cellule électrochimique (5) à un premier état de charge, et la deuxième limite de potentiel prédéfinie correspond à une deuxième tension pré-identifiée (V₂) de la cellule électrochimique (5) à un deuxième état de charge.

4. Procédé selon l'une quelconque des revendications précédentes, dans lequel le premier potentiel de circuit ouvert est déterminé à un premier emplacement sur l'électrode positive (8), et le deuxième potentiel de circuit ouvert est déterminé à un deuxième emplacement sur l'électrode négative (6), lesdits premier et deuxième emplacements correspondant à une région commune de l'électrode positive (8) et de l'électrode négative (6) à l'intérieur de la cellule électrochimique (5) avant l'extraction des électrodes positive et négative (8, 6).

5. Procédé selon l'une quelconque des revendications précédentes, dans lequel ladite première courbe de référence (38) est une première courbe de référence mise à l'échelle qui a été mise à l'échelle par rapport à une courbe de référence pour l'électrode positive (8) d'une cellule électrochimique non dégradée (5) pour tenir compte de la perte estimée ou prédéterminée de matière active dans la cellule électrochimique (5), et ladite deuxième courbe de référence (36) est une deuxième courbe de référence mise à l'échelle qui a été mise à l'échelle par rapport à une courbe de référence pour l'électrode négative (6) d'une cellule électrochimique non dégradée (5) pour tenir compte de la perte estimée ou prédéterminée de matière active dans la cellule électrochimique (5).

6. Procédé selon l'une quelconque des revendications précédentes, dans lequel les électrodes positive et négative (8, 6) ont été extraites de la cellule électrochimique (5) après que la cellule électrochimique (5) a été complètement déchargée.

7. Procédé selon l'une quelconque des revendications précédentes, dans lequel lesdites première et deuxième courbes de référence prédéterminées (38, 36) sont chacune déterminée par mesure du potentiel en circuit ouvert par rapport à l'échelle de potentiel présélectionnée en fonction de la charge d'une électrode d'une cellule électrochimique non dégradée (5) ayant la même configuration que la cellule électrochimique (5) qui est diagnostiquée, et éventuellement suivie d'une mise à l'échelle pour prendre en compte une perte estimée ou prédéterminée de matière active.

8. Procédé selon l'une quelconque des revendications précédentes, comprenant en outre la détermination d'une distribution de capacité restante dans la cellule électrochimique (5) en répétant les étapes a) à e) pour une pluralité d'emplacements sur les électrodes positive et négative (8, 6) correspondant à différentes régions à l'intérieur de la cellule électrochimique (5).

9. Procédé selon l'une quelconque des revendications précédentes, dans lequel le premier potentiel de cellule ouverte et le deuxième potentiel de cellule ouverte sont déterminés sans assembler des échantillons des électrodes positive et négative (8, 6) à une cellule de test.

10. Procédé selon l'une quelconque des revendications précédentes, dans lequel l'électrode de référence (20) comprend :
un séparateur poreux (23) configuré pour être mouillé avec un électrolyte et agencé de sorte qu'une surface du séparateur poreux (23) forme une extrémité distale (21) de l'électrode de référence (20), ladite extrémité distale (21) étant destinée à être en contact avec une électrode d'échantillon lorsque l'électrode de référence (20) est en service,
un ou plusieurs matériaux d'électrode de référence (24), sélectionnés pour fournir un potentiel de référence de l'échelle de potentiel présélectionnée, agencés à une distance de l'extrémité distale (21) et en contact direct avec le séparateur poreux (23),
une extrémité proximale (22) configurée pour être connectée à un circuit connecté à une électrode d'échantillon, et
un contact (25) configuré pour fournir une connexion électrique entre le ou les matériaux d'électrode de référence (24) et l'extrémité proximale (22).

11. Procédé selon la revendication 10, dans lequel la surface du séparateur poreux (23) formant l'extrémité distale (21) a une surface inférieure à 5 %, ou inférieure à 0,5 %, de la surface d'une face de l'électrode positive (8) ou de l'électrode négative (6).

12. Procédé selon l'une quelconque des revendications précédentes, dans lequel le procédé est exécuté par un dispositif de commande.

13. Procédé selon l'une quelconque des revendications 1 à 11, dans lequel l'électrode de référence (20) est une électrode de référence (20) actionnée manuellement.

14. Procédé selon l'une quelconque des revendications précédentes, dans lequel la cellule électrochimique (5) est une cellule à ions lithium.

15. Procédé selon la revendication 14, dans lequel l'échelle de potentiel présélectionnée est une échelle de potentiel choisie dans le groupe constitué par l'échelle Li/Li+, l'échelle LiFePO₄/FePO₄, l'échelle Li₇Ti₅O₁₂/Li₄Ti₅O₁₂ et l'échelle LiMn₂O₄/Li₂Mn₂O₄ .
